# EUROPEAN PATENT APPLICATION

(11) **EP 4 044 245 A1**
(43) Date of publication of application: **17.08.2022**
(21) Application number: 21774757.5
(22) Date of filing: 25.02.2021
(51) Int. Cl.: H01L 27/32

(54) **LEAD ARRANGEMENT STRUCTURE FOR OLED DISPLAY DEVICE AND DISPLAY DEVICE**

(30) Priority: 23.03.2020 CN 202020375985 U
(71) Applicant: BOE Technology Group Co., Ltd., Beijing 100015 (CN); Beijing BOE Technology Development Co., Ltd., Beijing 100176 (CN)
(72) Inventor: MA, Yongda, Beijing 100176 (CN); XIAN, Jianbo, Beijing 100176 (CN); HAO, Xueguang, Beijing 100176 (CN); QIAO, Yong, Beijing 100176 (CN)
(74) Representative: Haseltine Lake Kempner LLP
(86) International application number: PCT/CN2021/077933
(87) International publication number: WO 2021/190239

(57) **Abstract**

The present disclosure provides a lead arrangement structure for an OLED display device and a display device. The lead arrangement structure is disposed on a substrate of the display device. The substrate includes a display region and a lead region surrounding the display region. The lead arrangement structure includes first power lines disposed in the display region and second power lines disposed in the lead region, wherein each of the first power lines is electrically connected to a plurality of columns of sub-pixels, and one end of each of the second power lines is connected to a connection terminal on the substrate and the other end of the second power line is electrically connected to a plurality of the first power lines. The lead arrangement structure for the OLED display device and the display device according to the present disclosure can reduce the wiring workload of the power line, improve the utilization rate of the pixel space, and improve the display effect.

## Description

This application claims priority to the Chinese utility model patent application No. 202020375985.7, filed on March 23, 2020, and entitled "LEAD ARRANGEMENT STRUCTURE FOR OLED DISPLAY DEVICE AND DISPLAY DEVICE", the disclosure of which is herein incorporated by reference in its entirety.

### TECHNICAL FIELD

The present disclosure relates to the field of display technologies, and in particular, relates to a lead arrangement structure for an OLED display device and a display device.

### BACKGROUND

As the display size of the display substrate becomes larger and larger, the requirement for the resistance balance of signal lines on the substrate also becomes higher. And as the requirement for the number of pixels per inch (PPI) is increased, the number of pixels in the display region becomes denser, and the number of leads in the peripheral region continues to increase.

In organic light-emitting diode (OLED) displays, the power signal line (VDD signal line) of the pixel electrode is led out through the layered electrode. However, in large-size displays, it is difficult for a whole layer of VDD signal lines to balance the transmission resistance at two side edges and the middle region, resulting in that the consumption voltages of the power signals in different regions on the VDD signal line are different. Moreover, the VDD signal line is densely routed, leading to a high wiring workload in the pixel space, which in turn affects the display effect of the screen in different regions.

### SUMMARY OF THE UTILITY MODEL

An object of the present disclosure is to provide a lead arrangement structure for an OLED display device, so as to overcome the problems in the prior art that power signals consume different voltages on power lines, the power lines are densely routed, and the wiring workload in the pixel space is relatively high. The lead arrangement structure can reduce the wiring workload of the power lines, improve the utilization rate of the pixel space, and improve the display effect.

Another object of the present disclosure is to provide a display device including the above lead arrangement structure for the OLED display device.

In order to achieve the above objects, according to an aspect of the present disclosure, a lead arrangement structure for an OLED display device is provided. The lead arrangement structure is disposed on a substrate of the display device, the substrate including a display region and a lead region surrounding the display region, wherein the lead arrangement structure includes first power lines disposed in the display region and second power lines disposed in the lead region, wherein each of the first power lines is electrically connected to a plurality of columns of sub-pixels, and one end of each of the second power lines is connected to a connection terminal on the substrate and the other end of the second power line is electrically connected to a plurality of the first power lines.

In some embodiments, the lead arrangement structure further includes a connection layer, and the second power lines are electrically connected to the first power lines through the connection layer.

In some embodiments, the connection layer is provided with a plurality of via holes, and the second power lines are connected to the connection layer through the plurality of via holes.

In some embodiments, the number of the via holes corresponding to each of the second power lines is related to a number of the first power lines connected to the second power line.

In some embodiments, in a case that each of the via holes has a same area, a number of via holes corresponding to a third power line on the connection layer is greater than a number of via holes corresponding to a fourth power line on the connection layer, the third power line and the fourth power line are different power lines in the second power lines, and the third power line is farther away from a central axis of the substrate than the fourth power line is.

In some embodiments, a total area of all via holes corresponding to a third power line on the connection layer is greater than a total area of all via holes corresponding to a fourth power line on the connection layer, wherein the third power line and the fourth power line are different power lines in the second power lines, and the third power line is farther away from a central axis of the substrate than the fourth power line is.

In some embodiments, each of the via holes has a different area.

In some embodiments, the first power lines and the second power lines are disposed on different layers.

In some embodiments, a material of the connection layer is the same as a material of a layer where a gate line is disposed.

In some embodiments, the OLED display device includes a plurality of pixel units arranged in an array, and each of the pixel units includes a plurality of sub-pixels arranged in a row direction, and the sub-pixels of a same color in the plurality of pixel units form a column of sub-pixels.

In some embodiments, each of the first power lines is electrically connected to columns of sub-pixels in N pixel units, where N≥1.

In some embodiments, each of the second power lines is electrically connected to K first power lines, where K≥2.

In some embodiments, each of the pixel units includes three sub-pixels of different colors or four sub-pixels of different colors.

In some embodiments, the lead arrangement structure further includes a gate line disposed in the display region, and an included angle between each of the second power lines and the gate line is an acute angle.

In some embodiments, the lead arrangement structure further includes a first data line disposed in the display region and a second data line disposed in in the lead region, wherein one end of the second data line is connected to the connection terminal on the substrate, and the other end of the second data line is connected to the first data line.

In some embodiments, an included angle between at least part of the second data line and a gate line disposed in the display region is an acute angle.

In some embodiments, the first data line and the first power line are arranged parallel to each other.

In some embodiments, a width of each of the second power lines is positively correlated with a sum of widths of all the first power lines connected to the second power line.

According to another aspect of the present disclosure, a display device including any one of the above lead arrangement structures is provided.

### BRIEF DESCRIPTION OF THE DRAWINGS

FIGS. 1 and 2 are partial structural diagrams of a lead arrangement structure for an OLED display device according to a first embodiment of the present disclosure;
FIG. 3 is a partial structural diagram of a lead arrangement structure for an OLED display device according to a second embodiment of the present disclosure; and
FIGS. 4 and 5 are partial structural diagrams of a lead arrangement structure for an OLED display device according to a third embodiment of the present disclosure.

### DETAILED DESCRIPTION

In order to enable those skilled in the art to understand the technical solutions of the present disclosure better, the present disclosure will be described in detail below with reference to the accompanying drawings and specific embodiments. The following describes the embodiments of the present disclosure in further detail with reference to the accompanying drawings and specific embodiments, but it is not intended to limit the present disclosure.

Terms such as "first", "second" and the like used in the embodiments of the present disclosure do not denote any order, quantity, or importance, but are only intended to distinguish different parts. Terms such as "comprise" or "include" and the like mean that the element before the term covers the elements listed after the term, and does not exclude the possibility of covering other elements as well. Terms such as "up", "down", "left", "right" and the like are only intended to indicate the relative position relationship. When the absolute position of the described object changes, the relative position relationship may also change accordingly.

In the embodiments of the present disclosure, when it is described that a specific device is disposed between a first device and a second device, there may be or may not be an intervening device between the specific device and the first device or the second device. When it is described that a specific device is connected to another device, the specific device may be directly connected to the other device without an intervening device, or may not be directly connected to the other device but with an intervening device.

In the embodiments of the present disclosure, the term "same layer" refers to a relationship between layers simultaneously formed in the same step. For example, when a gate electrode and one or more power lines are formed for one or more steps of performing the same pattern processing on the material of the same layer, they are disposed in the same layer. In another example, by simultaneously performing the step of forming one gate electrode and the step of forming one or more power lines, the gate electrode and the one or more power lines may be formed in the same layer. The term "same layer" does not always mean that the thickness of the layer is the same or the layers in the cross-sectional view are the same.

All terms (including technical or scientific terms) used in the present disclosure have the same meaning as understood by those of ordinary skill in the art to which the present disclosure belongs, unless specifically defined otherwise. It should also be understood that terms such as those defined in general-purpose dictionaries should be interpreted as having meanings consistent with their meanings in the context of related technologies, and should not be interpreted in idealized or extremely formalized meanings, unless explicitly stated here.

The technologies, methods, and devices known to those of ordinary skill in the relevant fields may not be discussed in detail, but where appropriate, the technologies, methods, and devices should be regarded as part of the specification.

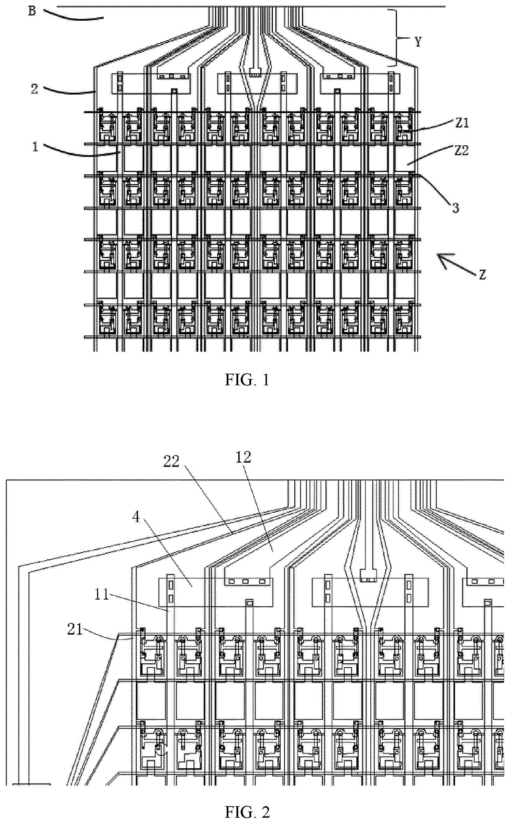

Hereinafter, some embodiments of the present disclosure are described with reference to FIGS. 1 to 5.

According to an aspect of the present disclosure, a lead arrangement structure for an OLED display device is provided. As shown in FIG. 1, the lead arrangement structure is disposed on a substrate B of the OLED display device. The substrate B includes a display region Z and a lead region Y surrounding the display region Z. The lead arrangement structure includes power lines 1 as well as data lines 2 and gate lines 3 arranged crosswise. The data lines 2 and gate lines 3 intersect to form a plurality of pixel regions. Each of the pixel regions is divided into a drive region Z1 and a light-emitting region Z2, that is, the display region Z includes the pixel drive region Z1 and the light-emitting region Z2, and the light-emitting region is a light-emergent region.

The power line 1 is configured to provide an electrical signal to a source electrode of a drive transistor in the OLED display device. The data line 2 is configured to provide an electrical signal to a source electrode of a switch transistor in the OLED display device. The gate line 3 is configured to provide an electrical signal to a gate of the switch transistor in the OLED display device.

In an exemplary embodiment, the drive transistor and the switch transistor are thin-film transistors (TFTs).

The gate line 3 is driven by a drive circuit on a gate line lead-in side. The drive circuit is a gate drive circuit. The gate drive circuit and the data line as well as the power line are connected to an external drive circuit outside the substrate through a lead-out terminal on the same side.

Further, as shown in FIG. 2, considering a large number of sub-pixels in the OLED display device, and in order to facilitate the power line 1 to effectively drive pixel electrodes of all sub-pixels to work, the power line 1 includes a first power line 11 and a second power line 12. Each first power line 11 is arranged in the display region Z and connected to a plurality of columns of sub-pixels in the display region Z. Each second power line 12 is arranged in the lead region Y outside the display region Z, one end of which is connected to a connection terminal on the substrate B, and the other end is connected to a plurality of first power lines 11. As such, each second power line 12 disposed in the lead region Y projecting from the substrate B can drive K first power lines 11 disposed in the display region Z, and each first power line 11 in the display region Z can drive pixel electrodes of N columns of sub-pixels to work, where K and N≥2. The number K of the first power lines 11 connected to the second power line 12 and the number N of columns of sub-pixels connected to the first power line 11 can be set as required. In addition, in the display region Z, in order to drive the pixel electrodes of the sub-pixels to work, the gate line 3 connected to the sub-pixels can be driven by the drive circuit on the gate line lead-in side, and the data line 2 and the power line 1 are lead out to the external circuit of the substrate B through the lead-out terminal on the same side.

In some embodiments, a width of each second power line 12 is positively correlated with a sum of widths of all the first power lines 11 connected thereto, that is, the greater the sum of the widths of all the first power line 11 connected to the second power line 12, the greater the width of the second power line 12, and vice versa, the smaller the sum of the widths of all the first power lines 11 connected to the second power line 12, the smaller the width of the second power line 12. In this way, the transmission stability of electric energy can be ensured.

In some embodiments, the power line 1 at different positions has different wiring distances, so it is necessary to adjust the width of the power line 1 at different positions to balance the resistance of the power line 1 at different positions.

For example, for two second power lines 12 connected to the same first power line 11, a second power line 12 that is proximal to the outside of the substrate is longer and wider, and a second power line 12 that is proximal to the inside of the substrate is shorter and narrower. The second power line 12 proximal to the outside of the substrate is farther away from a central axis of the substrate than the second power line 12 proximal to the inside of the substrate.

As another example, for two second power lines 12 connected to different first power lines 11, a second power line 12 connected to a first power line 11 proximal to the outside of the substrate is longer and wider, and a second power line 12 connected to a first power line 11 proximal to the inside of the substrate is shorter and narrower. The second power line 12 proximal to the outside of the substrate is farther away from the central axis of the substrate than the second power line 12 proximal to the inside of the substrate.

In order to reduce the wiring workload of the power line 1, in some embodiments, the first power line 11 and the second power line 12 are disposed on different layers, which facilitates the wiring of the power line 1, and at the same time realizes the connection between the power line 1 and the sub-pixels.

Further, in order to facilitate the cross-layer connection between the second power line 12 disposed on a first layer and the first power line 11 disposed on a second layer, in some embodiments, the lead arrangement structure further includes a connection layer 4. The connection layer is a conductor layer disposed on a different layer from the first power line 11. The second power line 12 disposed on the first layer is connected to the first power line 11 disposed on the second layer through the connection layer 4. The connection layer 4 can realize the transmission of electric energy between different power lines disposed on different layers, and a material thereof can be selected as required. In some embodiments, the material of the connection layer 4 is the same as a material of a layer where the gate line 3 is disposed, which can reduce the cost and realize the effective transmission of electric energy.

In an exemplary embodiment, the material of the connection layer is gate metal, such as Al (aluminum), Cu (copper), Mo (molybdenum), Cr (chromium), Ti (titanium), and other metals.

In other embodiments, the material of the connection layer is the same as a material of an anode layer or other conductive layers, which is not limited in the present disclosure.

Moreover, in some embodiments, the connection layer 4 is provided with a plurality of via holes, and the second power line 12 is connected to the connection layer 4 through the plurality of via holes. The number and size of the via holes can be adjusted according to factors such as the number of the second power lines 12, the size of the second power lines 12, and the area of the connection layer 4, such that the resistance of the corresponding power line 1 can be adjusted by adjusting the number and size of the via holes, and the power line 1 can have a more balanced resistance distribution in the entire region of the substrate B.

In some embodiments, the number of the via holes corresponding to each second power line 12 is related to the number of the first power lines 11 connected to the second power line 12. Generally, the more first power lines 11 connected to each second power line 12, the more via holes required, such that the resistance of the corresponding power line 1 can be adjusted by adjusting the number of the via holes. As a result, a plurality of power lines 1 can have a more balanced resistance distribution in the entire region of the substrate B.

Further, when each of the via holes has the same area, the number of the via holes corresponding to the second power line 12 disposed on the outside is greater than the number of the via holes corresponding to the second power wire disposed on the inside. Here, the outside refers to a position distal from the central axis of the substrate B. The farther the position from the central axis, the smaller an included angle between the second power line 12 and the first power line 11. The inside refers to a position proximal to the central axis of the substrate B. The closer the position to the central axis, the greater the included angle between the second power line 12 and the first power line 11. The number of the via holes can be designed in this way to achieve a balanced resistance.

That is, in a case that each of the via holes has the same area, the number of via holes corresponding to a third power line on the connection layer 4 is greater than the number of via holes corresponding to a fourth power line on the connection layer 4. The third power line and the fourth power line are respectively different power lines in the second power lines, and the third power line is farther away from the central axis of the substrate than the fourth power line is.

Further, in the case where it is difficult to set the number of the via holes, a contact area between the second power line 12 and the via holes can be increased based on the total area of the via holes, such that the total area of all the via holes corresponding to the second power line 12 disposed on the outside is greater than the total area of all the via holes corresponding to the second power line 12 disposed on the inside. As such, the total area of the via holes disposed on the outside is greater, which is beneficial to increase the contact area between the second power line 12 and the via holes, and further realize resistance balance of each second power line 12.

Further, when each of the via holes has a different area, it is only necessary to ensure that the total area of all the via holes corresponding to the second power line 12 disposed on the outside is larger than that the total area of all the via holes corresponding to the second power line 12 disposed on the inside.

That is, the total area of the via holes corresponding to the third power line on the connection layer 4 is larger than the total area of the via holes corresponding to the fourth power line on the connection layer 4.

As described above, each of the first power lines 11 is arranged in the display region Z and connected to a plurality of columns of sub-pixels in the display region Z, wherein the arrangement and colors of at least two columns of sub-pixels can be set as required. In some embodiments, the OLED display device includes a plurality of pixel units arranged in rows. Each of the pixel units includes a plurality of the sub-pixels arranged laterally (i.e., in a row direction), and the sub-pixels with the same color in the plurality of pixel units form a column of sub-pixels. In this way, each first power line 11 can drive a plurality of columns of sub-pixels with the same color, thereby reducing the wiring workload of the power line 1.

Based on the above lead arrangement structure for the OLED display device, according to the number of sub-pixels included in the pixel unit, there may also be but not limited to the following two embodiments.

### First embodiment

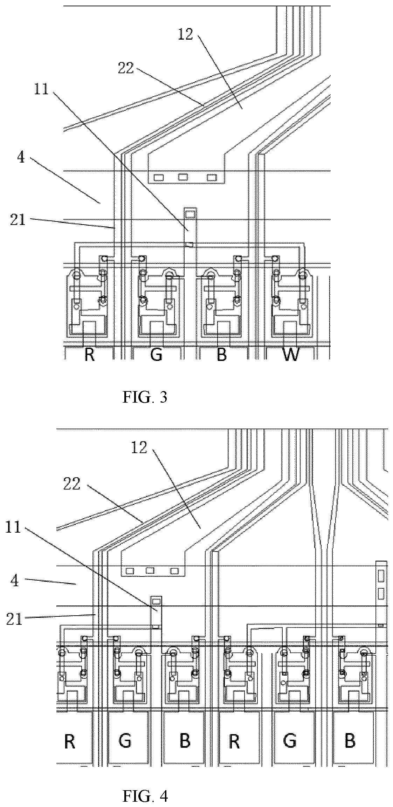

In each row of the display region Z, N1 pixel units arranged adjacent to each other are driven by the same first power line 11, where N1≥1, and each of the pixel units includes four laterally arranged pixels of different colors, thereby forming an arrangement with a plurality of rows of sub-pixels. The structure of each pixel unit is shown in FIG. 3. Each of the pixel units includes four sub-pixels corresponding to different colors, which include a red (R) sub-pixel, a green (G) sub-pixel, a blue (B) sub-pixel, and a white (W) sub-pixel respectively. The first power line 11 in the display region Z drives the sub-pixels corresponding to four different colors, such that each first power line 11 can provide a power signal to 4×N1 columns of sub-pixels. The total number of columns of sub-pixels on the substrate B is M. Since the number of the first power lines 11 is generally greater than 2, then N1<(M/8). The second power line 12 disposed in the lead region Y can be connected to the first power lines 11 in 4×K1 pixel regions Z, where K1≥2.

In an exemplary embodiment, each first power line 11 can provide a power signal to 4 columns of sub-pixels in the same column of pixel units, that is, to provide a power signal to one column of pixel units. In this case, the number of the first power lines 11 is the number of columns of pixel units on the substrate B.

### Second embodiment

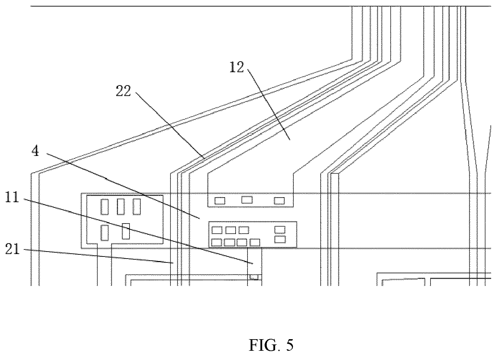

In each row of the display region Z, N2 pixel units arranged adjacent to each other are driven by the same first power line 11, where N2≥1, and each of the pixel units includes three laterally arranged sub-pixels of different colors, thereby forming an arrangement with a plurality of rows of sub-pixels. The structure of each pixel unit is shown in FIGS. 4 and 5. Each of the pixel units includes three sub-pixels corresponding to different colors, which includes a red (R) sub-pixel, a green (G) sub-pixel, and a blue (B) sub-pixel. The first power line 11 in the display region Z drives three sub-pixels corresponding to different colors. In this way, each first power line 11 can provide a power signal to 3×N2 columns of sub-pixels. The total number of columns of sub-pixels on the substrate B is M. Since the number of the first power lines 11 is generally greater than 2, then N2<(M/6). The second power line 12 disposed in the lead region Y is connected to the first power lines 11 in 3 xK2 pixel regions, where K2≥2.

In an exemplary embodiment, each first power line 11 can provide a power signal to three sub-pixels of the same column of pixel units, that is, to provide a power signal to one column of pixel units. In this case, the number of the first power lines 11 is the number of columns of pixel units on the substrate B.

In order to facilitate in converging the second power line 12 to the connection terminal of the substrate B, in some embodiments, an included angle between the second power line 12 and the gate line 3 disposed in the display region is an acute angle.

In order to facilitate the connection of the data line 2 and the gate line 3 with the sub-pixels arranged in columns to form the display region Z and connect to the connection terminal on the substrate B, in some embodiments, the data line 2 includes a first data line 21 and a second data line 22. The first data line 21 is arranged in the display region Z. The second data line 22 is arranged in the lead region Y. One end of the second data line 22 is connected to the connection terminal on the substrate B, and the other end is connected to the first data line 21.

Further, in order to facilitate converging the second data line 22 to the connection terminal of the substrate B, in some embodiments, an included angle between at least part of the second data line 22 and the gate line disposed in the display region 3 is an acute angle.

In addition, in some embodiments, the first data line 21 and the first power line 11 are arranged parallel to each other, which can reduce the crossing of the first data line 21 and the first power line 11, such that the layout of the lead arrangement structure is more reasonable and the display effect is improved.

In the above technical solution, the power line 1 includes a first power line 11 and a second power line 12, each first power line 11 is connected to a plurality of columns of sub-pixels in the display region, and each second power line 12 is arranged in the lead region Y outside the display region, one end of which is connected to the connection terminal on the substrate B, and the other end is connected to a plurality of first power lines 11, that is, each first power line 11 can drive a plurality of columns of sub-pixels, and each second power line 12 can drive a plurality of first power lines 11, thereby reducing the wiring workload of the power line 1, improving the utilization of the pixel space, and improving the display effect. In addition, in the related art, the power line is led out by a whole layer of conductive layer in the lead region, which causes different power signal losses in different regions on the power line. In the present disclosure, one power line is adopted to drive a plurality of columns of sub-pixels, which is equivalent to providing the power line in different regions and is beneficial to the resistance balance of the power signal on a large-size display.

According to a second aspect of the present disclosure, a display device is provided. The display device includes the above lead arrangement structure. The display device in the embodiment of the present disclosure may be any product or component with a display function, such as a mobile phone, a tablet computer, a television, a monitor, a notebook computer, a digital photo frame, a navigator, and the like. Since the display device has the above lead arrangement structure, it has all or at least part of the advantages of the lead arrangement structure. In the display device of the present disclosure, the wiring workload of the power line 1 is low, the utilization rate of the pixel space is high, the high resolution is achieved, and the display effect is good.

In addition, although the exemplary embodiments have been described herein, the scope thereof includes any or all embodiments with equivalent elements, modifications, omissions, combinations (e.g., solutions where various embodiments are crossed), adaptations, or changes based on the present disclosure. The elements in the claims can be interpreted broadly based on the language adopted in the claims, and are not limited to the examples described in this specification or during the implementation of the present disclosure, and the examples are interpreted as non-exclusive. Therefore, this specification and examples are intended to be regarded as examples only, and the true scope and spirit are indicated by the appended claims and the full scope of their equivalents.

The above description is intended to be illustrative and not restrictive. For example, the above examples (or one or more of them) can be used in combination with each other. For example, a person of ordinary skill in the art may use other embodiments when reading the above description. In addition, in the above-detailed description, various features may be grouped to simplify the present disclosure. This should not be construed as an intent that an unclaimed disclosed feature is necessary for any claim. On the contrary, the subject matter of the present disclosure may be less than all the features of a specifically disclosed embodiment. Thus, the appended claims are incorporated into the detailed description as examples or embodiments, wherein each claim is independently regarded as a separate embodiment, and it is considered that these embodiments can be combined with each other in various combinations or permutations. The scope of the present disclosure should be determined with reference to the appended claims and the full scope of equivalents entitled by these claims.

The above embodiments are only exemplary embodiments of the present disclosure and are not intended to limit the present disclosure. The scope of protection of the present disclosure is defined by the claims. Those skilled in the art can make various modifications or equivalent substitutions to the present disclosure within the essence and scope of protection of the present disclosure, and such modifications or equivalent substitutions should also be regarded as falling within the scope of protection of the present disclosure.

## Claims

1. A lead arrangement structure for an OLED display device, disposed on a substrate of the display device, the substrate comprising a display region and a lead region surrounding the display region, wherein
the lead arrangement structure comprises first power lines disposed in the display region and second power lines disposed in the lead region, wherein each of the first power lines is electrically connected to a plurality of columns of sub-pixels, and one end of each of the second power lines is connected to a connection terminal on the substrate and the other end of the second power line is electrically connected to a plurality of the first power lines.

2. The lead arrangement structure according to claim 1, further comprising a connection layer, wherein the second power lines are electrically connected to the first power lines through the connection layer.

3. The lead arrangement structure according to claim 2, wherein the connection layer is provided with a plurality of via holes, the second power lines being connected to the connection layer through the plurality of via holes.

4. The lead arrangement structure according to claim 3, wherein the number of the via holes corresponding to each of the second power lines is related to a number of the first power lines connected to the second power line.

5. The lead arrangement structure according to claim 3, wherein in a case that each of the via holes has a same area, a number of via holes corresponding to a third power line on the connection layer is greater than a number of via holes corresponding to a fourth power line on the connection layer, the third power line and the fourth power line being different power lines in the second power lines, and the third power line being farther away from a central axis of the substrate than the fourth power line being.

6. The lead arrangement structure according to claim 3, wherein a total area of all via holes corresponding to a third power line on the connection layer is greater than a total area of all via holes corresponding to a fourth power line on the connection layer, the third power line and the fourth power line being different power lines in the second power lines, and the third power line being farther away from a central axis of the substrate than the fourth power line being.

7. The lead arrangement structure according to claim 6, wherein each of the via holes has a different area.

8. The lead arrangement structure according to any one of claims 2 to 7, wherein the first power lines and the second power lines are disposed on different layers.

9. The lead arrangement structure according to any one of claims 2 to 7, wherein a material of the connection layer is the same as a material of a layer where a gate line is disposed.

10. The lead arrangement structure according to any one of claims 1 to 9, wherein the OLED display device comprises a plurality of pixel units arranged in an array, and each of the pixel units comprises a plurality of sub-pixels arranged in a row direction, and the sub-pixels of a same color in the plurality of pixel units form a column of sub-pixels.

11. The lead arrangement structure according to claim 10, wherein each of the first power lines is electrically connected to columns of sub-pixels in N pixel units, where N≥1.

12. The lead arrangement structure according to claim 10, wherein each of the second power lines is electrically connected to K first power lines, where K≥2.

13. The lead arrangement structure according to claim 10, wherein each of the pixel units comprises three sub-pixels of different colors or four sub-pixels of different colors.

14. The lead arrangement structure according to any one of claims 1 to 13, further comprising a gate line disposed in the display region, wherein an included angle between each of the second power lines and the gate line is an acute angle.

15. The lead arrangement structure according to any one of claims 1 to 14, further comprising a first data line disposed in the display region and a second data line disposed in the lead region, wherein one end of the second data line is connected to the connection terminal on the substrate, and the other end of the second data line is connected to the first data line.

16. The lead arrangement structure according to claim 15, wherein an included angle between at least part of the second data line and a gate line disposed in the display region is an acute angle.

17. The lead arrangement structure according to claim 15, wherein the first data line and the first power line are arranged in parallel to each other.

18. The lead arrangement structure according to any one of claims 1 to 17, wherein a width of each of the second power lines is positively correlated with a sum of widths of all the first power lines connected to the second power line.

19. A display device comprising the lead arrangement structure as defined in any one of claims 1-18.
